# EUROPÄISCHE PATENTSCHRIFT

(11) **EP 2 585 554 B1**
(45) Veröffentlichungstag und Bekanntmachung des Hinweises auf die Patenterteilung: **31.08.2016**
(21) Anmeldenummer: 11727415.9
(22) Anmeldetag: 07.06.2011
(51) Int. Cl.: C09K 11/77, H05B 33/14, C09K 11/08, H01J 1/63, H05B 33/12, H01L 33/50

(54) **LEUCHTSTOFF UND LICHTQUELLE MIT DERARTIGEM LEUCHTSTOFF**
LUMINESCENT SUBSTANCE AND LIGHT SOURCE HAVING SUCH A LUMINESCENT SUBSTANCE
LUMINOPHORE ET SOURCE LUMINEUSE DOTÉ D'UN TEL LUMINOPHORE

(30) Priorität: 24.06.2010 DE 102010030473
(43) Veröffentlichungstag der Anmeldung: 01.05.2013
(73) Patentinhaber: OSRAM GmbH, 80807 München (DE)
(72) Erfinder: HUCKENBECK, Barbara, 86159 Augsburg (DE); POHL, Bianca, 82205 Gilching (DE); HUBER, Günter, 86529 Schrobenhausen (DE); JERMANN, Frank, 86343 Königsbrunn (DE)
(74) Vertreter: Epping - Hermann - Fischer
(86) Internationale Anmeldenummer: PCT/EP2011/059412
(87) Internationale Veröffentlichungsnummer: WO 2011/160944

(56) Entgegenhaltungen:
- EP-A1- 0 383 388
- AT-B- 410 266
- US-A1- 2005 077 532
- US-A1- 2006 081 814
- US-A1- 2006 232 193
- US-A1- 2006 267 031
- DATABASE INSPEC [Online] THE INSTITUTION OF ELECTRICAL ENGINEERS, STEVENAGE, GB; 1. August 2008 (2008-08-01), WANG XIFENG ET AL: "Preparation, luminescence and application of Sr2-xBaxSiO4:Eu phosphor for light-emitting diodes", XP000002656968, Database accession no. 10508701 & JOURNAL OF THE CHINESE CERAMIC SOCIETY CHINESE CERAMIC SOCIETY CHINA, Bd. 36, Nr. 8, 1. August 2008 (2008-08-01) , - 1. August 2008 (2008-08-01), Seiten 1119-1123, ISSN: 0454-5648
- KANG H S ET AL: "The enhancement of photoluminescence characteristics of Eu-doped barium strontium silicate phosphor particles by co-doping materials", JOURNAL OF ALLOYS AND COMPOUNDS, ELSEVIER SEQUOIA, LAUSANNE, CH, Bd. 402, Nr. 1-2, 27. Oktober 2005 (2005-10-27), Seiten 246-250, XP025330423, ISSN: 0925-8388, DOI: 10.1016/J.JALLCOM.2005.04.143 [gefunden am 2005-10-27]
- JUNG-SANG CHO ET AL: "Green-Emitting Silicate Phosphor Under Long Wavelength Ultraviolet Prepared by High Temperature Flame Spray Pyrolysis", KOREAN JOURNAL OF MATERIALS RESEARCH, Bd. 18, Nr. 2, 25. Februar 2008 (2008-02-25), Seiten 77-83, XP55004990, ISSN: 1225-0562, DOI: 10.3740/MRSK.2008.18.2.077

## Beschreibung

### Technisches Gebiet

Die Erfindung geht aus von einem Leuchtstoff gemäß dem Oberbegriff des Anspruchs 1 und einer mit derartigem Leuchtstoff ausgestatteten Lichtquelle gemäß Anspruch 4, insbesondere einer Konversions-LED. Derartige Konversions-LEDs sind insbesondere für Allgemeinbeleuchtung geeignet.

### Stand der Technik

Aus der US-B 7 489 073 ist eine Konversions-LED bekannt, die als Leuchtstoff ein modifiziertes reguläres Orthosilikat verwendet.

Stabile grüne Leuchtstoffe, insbesondere mit einem Emissionsmaximum um 520-540 nm, stehen kaum zur Verfügung. Das erschwert den Einsatz von Konversions-LEDs bei der Displayhinterleuchtung und schränkt die Optimierung von High-CRI-LEDs oder Warmweiß-LEDs ein. Bisher werden in Produkten hauptsächlich Orthosilikate als Grünleuchtstoffe für diesen Bereich eingesetzt. Diese besitzen zwar teils hohe Quanteneffizienzen, zeigen aber ein unzureichendes Alterungsverhalten in LEDs.

Aus der US-B 7,489,073 ist ein Nitrido-Orthosilikat mit der Zusammensetzung AE_{2-**x**-a}RE**ₓ**EuₐSiO₄₋ₓNₓ (AE=Sr, Ba, Ca, Mg; RE=Seltene Erden, insbesondere Y und/oder La) bekannt. EA oder auch AE steht hier für Erdalkali-Elemente. Durch den Einbau von YN und/oder LaN wird eine Rotverschiebung der spektralen Lage und zumeist eine Verbesserung der Quanteneffizienz des Leuchtstoffes erreicht. Das LED-Alterungsverhalten dieses- Leuchtstoffs ist bereits mit dem dort beschriebenen Herstellverfahren deutlich besser als bei den konventionellen Orthosilikaten oder anderen grünen Sion-Leuchtstoffen wie z. B.
Ba₃Si₆O₁₂N₂: Eu.

Die US 2006/232109 A1 offenbart einen Leuchtstoff der Formel AE₂₋ₓ₋ₐREₓEuₐSiO₄-xNₓ mit AE = Sr, Ba, Ca oder Mg und RE = Seltene Erden.

Für viele Anwendungen, wie z. B. für LCD-Hintergrundbeleuchtung, ist die Stabilität in feuchter Umgebung und bei höheren Temperaturen jedoch immer noch nicht optimal.

### Darstellung der Erfindung

Die Aufgabe der vorliegenden Erfindung ist es, einen Leuchtstoff gemäß dem Oberbegriff des Anspruchs 1 bereitzustellen, der es gestattet, die Eigenschaften von nitridischen Leuchtstoffen gezielt an spezielle Aufgaben anzupassen.

Diese Aufgabe wird gelöst durch die kennzeichnenden Merkmale des Anspruchs 1.

Besonders vorteilhafte Ausgestaltungen finden sich in den abhängigen Ansprüchen.

Erfindungsgemäß wird jetzt ein neuartiger nitridischer Leuchtstoff bereitgestellt. Darunter fallen blau bzw. blau-grün bis gelb emittierende Leuchtstoffe, die insbesondere im Emissionsbereich typischer UV- und Blau-LEDs anregbar sind und gleichzeitig eine sehr hohe Stabilität in der LED aufweisen. Anwendungen können die Leuchtstoffe insbesondere in LEDs mit guter Farbwiedergabe, in LEDs für LCD-Hintergrundbeleuchtung, Color-on-demand LEDs oder weißen OLEDs finden.

Weiße LEDs gewinnen in der Allgemeinbeleuchtung immer mehr an Bedeutung. Insbesondere steigt die Nachfrage nach warmweißen LEDs mit niedrigen Farbtemperaturen und guter Farbwiedergabe und gleichzeitig hoher Effizienz. Vor dem Hintergrund des kommenden Verbots der wenig energieeffizienten Allgebrauchsglühlampe gewinnen alternative Lichtquellen mit möglichst guter Farbwiedergabe (CRI) immer mehr an Bedeutung. Viele Verbraucher legen Wert auf Leuchtmittel mit glühlampenähnlichem Lichtspektrum.

Die Leuchtstoffe müssen eine Reihe von Anforderungen erfüllen: Eine sehr hohe Stabilität gegenüber chemischen Einflüssen, beispielsweise Sauerstoff, Feuchtigkeit, Wechselwirkungen mit Vergussmaterialien, sowie gegenüber Strahlung. Um einen stabilen Farbort bei steigender Systemtemperatur zu gewährleisten, sind außerdem Leuchtstoffe erforderlich, die ein geringes Temperaturlöschverhalten aufweisen.

Derartige Leuchtstoffe werden in weißen LEDs und Color-on-Demand LEDs eingesetzt.

Die Anregung derartiger Leuchtstoffe geschieht bevorzugt mit kurzwelliger Strahlung im UV und kurzwelligen Blau, insbesondere im Bereich 360 bis 480 nm.

Die Erfindung basiert auf der Bereitstellung von Leuchtstoffen aus den Stoffklassen der Nitrido-Orthosilikate.

Es hat sich gezeigt, dass ein erfindungsgemäßer Unterschuss an SiO₂ zu höheren Quanteneffizienzen führt. Damit ergibt sich eine Zusammensetzung der Ansatzmischung für das stabilisierte Nitrido-Orthosilikat von EA₂₋ₓ₋ₐSEₓEuₐSi_{1-y}O_{4-x-2y}Nₓ (EA=Sr, Ba, Ca, Mg; SE = Seltene Erden, insbesondere Y und/oder La), wobei x bevorzugt zwischen 0,003 und 0,02, a bevorzugt zwischen 0,01 und 0,2 liegt. Der für den SiO₂-Unterschuss maßgebende Faktor y kann im Bereich zwischen 0 < y ≤ 0,1 liegen, erfindungsgemäß liegt y im Bereich von 0,002 ≤ y ≤ 0,02. Bei dem hier beschriebenen Verfahren zur Herstellung eines stabilisierten Nitrido-Orthosilikats erweitert sich außerdem bevorzugt in einer Ausführungsform die Eduktseite um Si₃N₄ und La₂O₃ bzw. Y₂O₃.

Für die Präparation von EA₂₋ₓ₋ₐSEₓEuₐSi_{1-y}O_{4-x-2y}Nₓ benötigt man entweder EACO₃, SiO₂, (La,Y)N und Eu₂O₃ oder EACO₃, SiO₂, Si₃N₄, (La,Y)₂O₃ und Eu₂O₃ als Ausgangssubstanzen. Weiterhin können insbesondere Fluoride und Chloride, wie EACl₂, EAF₂, aber auch NH₄Cl/NH₄F, H₃BO₃, LiF und Kryolithe, sowie Kombinationen davon, als Schmelzmittel eingesetzt werden.

Wesentliche Merkmale der Erfindung in Form einer nummerierten Aufzählung sind:
1. Blau bis Gelb emittierender Leuchtstoff aus der Klasse der Orthosilikate, der im wesentlichen die Struktur EA2SiO4:D besitzt, dadurch gekennzeichnet, dass der Leuchtstoff als Komponente EA = Sr, Ba, Ca oder Mg allein oder in Kombination aufweist, wobei die aktivierende Dotierung D aus Eu besteht und einen Anteil von EA ersetzt, und wobei SiO2 im Unterschuss eingebracht ist, so dass ein modifiziertes unterstöchiometrisches Orthosilikat vorliegt.
2. Der Leuchtstoff ist dadurch gekennzeichnet, dass das Orthosilikat ein mit SE und N stabilisiertes Orthosilikat ist, mit SE = Seltenerdmetall, so dass die Stöchiometrie EA₂₋ₓ₋ₐSEₓEuₐSi1-yO_{4-x-2y}Nₓ entspricht. Der Anteil a des Eu beträgt zwischen a = 0,01 und 0,20. Der Anteil x beträgt zwischen 0,003 und 0,02. Der Leuchtstoff ist dadurch gekennzeichnet, dass der für den Unterschuss maßgebende Faktor y zwischen 0,002 ≤ y ≤ 0,02, liegt. Der für den Unterschuss maßgebende Faktor y kann im Bereich von 0 < y ≤ 0,1 liegen.
3. In einer Ausführungsform ist der Leuchtstoff dadurch gekennzeichnet, dass SE = La oder Y allein oder in Kombination ist.
4. In einer Ausführungsform ist der Leuchtstoff dadurch gekennzeichnet, dass EA Sr und/oder Ba mit mindestens 66 mol-% enthält, insbesondere mit einem Anteil des Ca von maximal 5 mol-% und insbesondere mit einem Anteil des Mg von maximal 30 mol-%.
5. Die Erfindung betrifft eine Lichtquelle mit einer primären Strahlungsquelle, die Strahlung im kurzwelligen Bereich des optischen Spektralbereichs im Wellenlängenbereich 140 bis 480 nm emittiert, wobei diese Strahlung mittels eines ersten Leuchtstoffs nach einer der vorhergehenden erfindungsgemäßen Ausführungsformen ganz oder teilweise in sekundäre längerwellige Strahlung im sichtbaren Spektralbereich konvertiert wird.
6. In einer Ausführungsform ist die Lichtquelle dadurch gekennzeichnet, dass als primäre Strahlungsquelle eine Leuchtdiode auf Basis von InGaN oder InGaAlP oder eine Entladungslampe auf Niederdruck- oder Hochdruckbasis, insbesondere mit einer Indiumhaltigen Füllung, oder eine elektrolumineszente Lampe verwendet wird.
7. In einer Ausführungsform ist die Lichtquelle dadurch gekennzeichnet, dass ein Teil der primären Strahlung weiterhin mittels weiterer Leuchtstoffe in längerwellige Strahlung konvertiert wird, wobei die Leuchtstoffe insbesondere geeignet gewählt und gemischt sind um weißes Licht zu erzeugen.
8. Es wird ein Verfahren zur Herstellung eines hocheffizienten Leuchtstoffs nach einem der erfindungsgemäßen Ausführungsformen angegeben. Das Verfahren ist gekennzeichnet durch folgende Verfahrensschritte:
   a) Bereitstellen der Ausgangsstoffe SiO₂ allein oder in Kombination mit Si₃N₄ als Si-Komponente, sowie mindestens eines SE-Vorläufers ausgewählt aus der Gruppe SEN oder SE203, sowie mindestens eines EA-Vorläufers, bevorzugt EACO3, insbesondere mindestens ein Vorläufer aus der Gruppe SrCO₃, BaCO3, CabO₃ und MgO, sowie eines Eu-Vorläufers, insbesondere Eu203, wobei die Si-Komponente in unterstöchiometrischem Anteil bereitgestellt wird;
   b) Mischen der Ausgangsstoffe und Glühung für mindestens 1 Std. unter reduzierender Atmosphäre bei Temperaturen von 1000 bis 1500 °C;
   c) ggf. anschließendes zweites Glühen des in Schritt b) hergestellten Leuchtstoffs bei 800 bis 1400 °C.
9. In einer Ausführungsform ist das Verfahren dadurch gekennzeichnet, dass Fluoride oder Chloride, insbesondere mindestens eines aus der Gruppe EAF2, EAC12, SEC12 oder SEF2, oder von Ammonium, oder auch H3B03, oder-LiF oder Kryolithe allein oder in Kombination als Schmelzmittel beim Schritt a) und/oder beim Schritt c) eingesetzt werden.
10. Es wird eine Konversions-LED angegeben: Konversions-LED mit einem Chip, der primäre Strahlung emittiert, sowie einer dem Chip vorgelagerten Leuchtstoff enthaltenden Schicht, die mindestens einen Teil der primären Strahlung des Chips in sekundäre Strahlung konvertiert, wobei ein Leuchtstoff gemäß einem der erfindungsgemäßen Ausführungsformen verwendet wird.
11. In einer Ausführungsform ist die Konversions-LED dadurch gekennzeichnet, dass als weiterer Leuchtstoff zur Erzeugung von Weiß (Lu,Y,Gd)₃(Al,Ga)₅O₁₂:Ce verwendet wird.
12. In einer Ausführungsform ist die Konversions-LED dadurch gekennzeichnet, dass als weiterer Leuchtstoff ein durch Cu modifiziertes CaAlSiN3:Eu verwendet wird.

### Kurze Beschreibung der Zeichnungen

Im Folgenden soll die Erfindung anhand mehrerer Ausführungsbeispiele näher erläutert werden. Die Figuren zeigen:
- Fig. 1: eine Konversions-LED;
- Fig. 2: ein LED-Modul mit entfernt angebrachter Leuchtstoffmischung;
- Fig. 3: ein Emissionsspektrum einer LCD-Backlight-LED mit einer Mischung aus einem grünen Leuchtstoff des Typs (Sr,Ba,La)₂Si_{1-y}O_{4-x-2y}Nₓ:Eu²⁺ und einem roten Leuchtstoff des Typs Alumonitridosilikat CaAl-SiN3 : Eu²⁺
- Fig. 4: einen Vergleich der Emission einer LED mit dem Leuchtstoff des Typs (Sr,Ba,La)₂Si_{1-y}O_{4-x-2y}Nₓ : Eu²⁺ bei unterschiedlichen Leuchtstoffkonzentrationen
- Fig. 5: einen Vergleich der Änderung des Konversionsverhältnisses (Grün-/Blau-Emission) pro 1 h.ermittelt nach einer vorhergehenden LED-Betriebsdauer von ca. 6 h bei einer Umgebungstemperatur von 45°C und 95% Luftfeuchtigkeit (LED auf Leiterplatte ohne zusätzliche Kühlung montiert; LED-Stromdichte 500 mA/mm²).

### Bevorzugte Ausführungsform der Erfindung

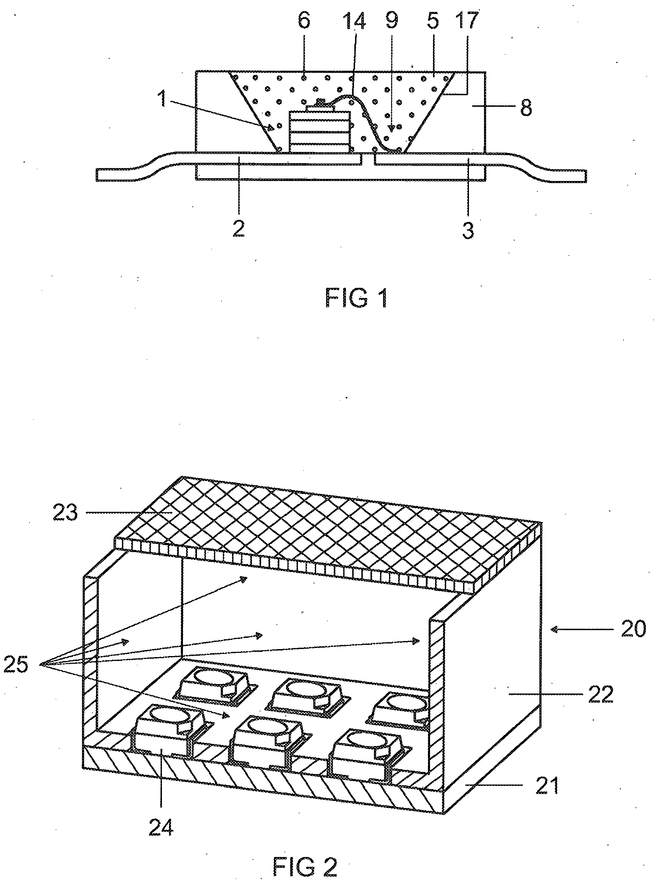

Figur 1 zeigt den Aufbau einer Konversions-LED für weißes Licht auf RGB-Basis wie an sich bekannt. Die Lichtquelle ist ein Halbleiterbauelement mit einem blau emittierende Chip 1 des Typs InGaN mit einer Peakemissionswellenlänge von 435 bis 455 nm Peakwellenlänge, beispielsweise 445 nm, das in ein lichtundurchlässiges Grundgehäuse 8 im Bereich einer Ausnehmung 9 eingebettet ist. Der Chip 1 ist über einen Bonddraht 14 mit einem ersten Anschluss 3 und direkt mit einem zweiten elektrischen Anschluss 2 verbunden. Die Ausnehmung 9 ist mit einer Vergussmasse 5 gefüllt, die als Hauptbestandteile ein Silikon (60- 90 Gew.-%) und Leuchtstoffe 6 (etwa 15 bis 40 Gew.-%) enthält. Ein erster Leuchtstoff ist ein grün emittierender Nitrido-Orthosilikat-Leuchtstoff EA₂₋ₓ₋ₐSEₓEuₐSi_{1-y}O_{4-x-2y}Nₓ mit EA ist Ba und mit SE ist Y. Andere Ausführungsbeispiele verwenden zumindest eines der folgenden Elemente: für EA = Ba,Sr,Ca,Mg und für SE = La,Y. Außerdem wird als zweiter Leuchtstoff ein rot emittierender Leuchtstoff, beispielsweise ein Alumonitridosilikat oder Calsin verwendet. Die Ausnehmung hat eine Wand 17, die als Reflektor für die Primär- und Sekundärstrahlung vom Chip 1 bzw. den Leuchtstoffen 6 dient. Konkrete Ausführungsbeispiele für weitere Leuchtstoffe sind zur Erzeugung von Weiß (Lu,Y,Gd)₃(Al,Ga)₅O₁₂:Ce oder auch ein durch Cu modifiziertes CaAlSiN3:Eu.

Grundsätzlich ist die Verwendung der Leuchtstoff-Mischung als Dispersion, als Dünnfilm etc. direkt auf der LED oder auch, wie an sich bekannt, auf einem separaten, der LED vorgeschalteten Träger möglich.

Figur 2 zeigt ein derartiges Modul 20 mit diversen LEDs 24 auf einer Grundplatte 21. Darüber ist ein Gehäuse montiert mit Seitenwänden 22 und einer Deckplatte 12. Die Leuchtstoff-Mischung ist hier als Schicht 25 sowohl auf den Seitenwänden als auch vor allem auf der Deckplatte 23, die transparent ist, angebracht.

Andere geeignete Lichtquellen sind Leuchtstofflampen oder Hochdruckentladungslampen, bei denen der neuartige Leuchtstoff zur Konversion der primären Strahlung herangezogen werden kann, allein oder in Kombination mit anderen Leuchtstoffen.

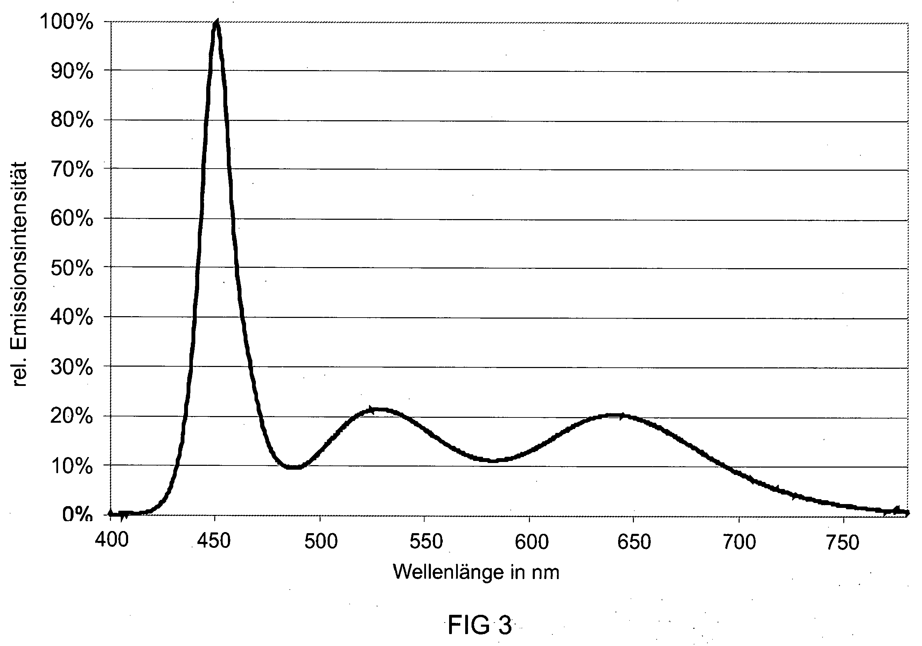

Figur 3 zeigt das Spektrum einer LCD-Backlight-LED auf Basis zweier Leuchtstoffe. Auf der Abszisse ist die Wellenlänge in nm, auf der Ordinate die relative Emissionsintensität aufgetragen. Ein erster eingebrachter Leuchtstoff ist ein Rotleuchtstoff des Typs CaAlSiN3 : Eu, der zweite ist ein erfindungsgemäßer Grünleuchtstoff mit der Ansatzstöchiometrie (Ba, Sr)₂₋ₓ₋ₐLaₓEuₐSi_{1-y}O_{4-x-2y}Nₓ mit x = 0,005, a = 0,08 und y = 0,0075.

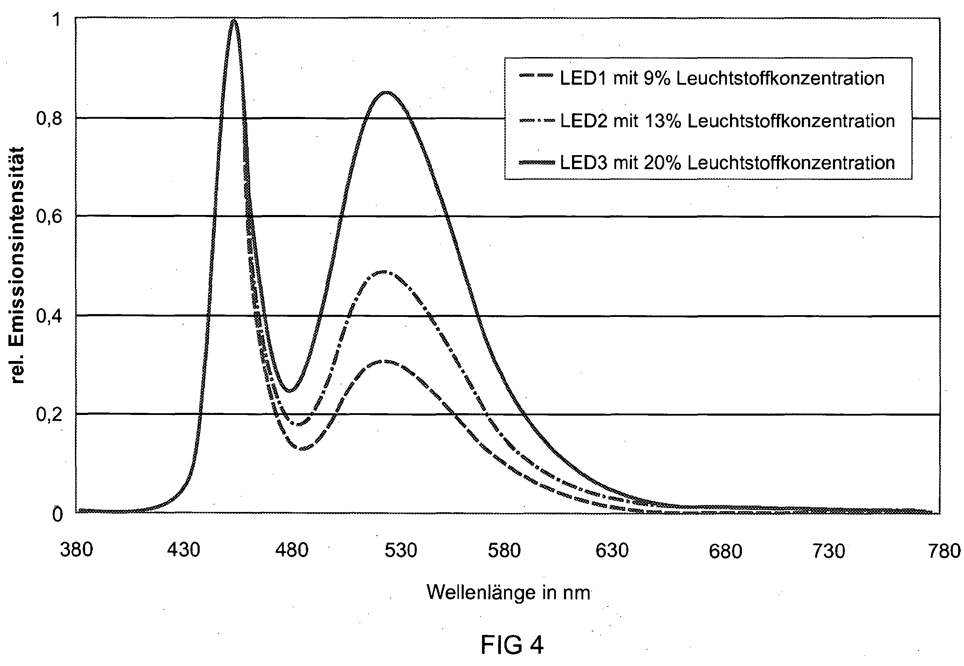

Figur 4 zeigt einen Vergleich von Emissionsspektren von LEDs mit eingebrachten Leuchtstoffkonzentrationen von 9, 13 und 20 Gew.-% . Der Leuchtstoff ist ein erfindungsgemäßer Grünleuchtstoff mit der Ansatzstöchiometrie (Ba, Sr)₂₋ₓ₋ₐLaₓEuₐSi_{1-y}O_{4-x-2y}Nₓ mit x = 0,005, a = 0,08 und y = 0,0075. Auf der Abszisse ist die Wellenlänge in nm, auf der Ordinate die relative Emissionsintensität aufgetragen.

Die Herstellung des neuartigen unterstöchiometrischen Leuchtstoffs gelingt auf folgende Weise:

Die Edukte analog den Ansatzmischungen 1 bis 4 werden, bevorzugt zusammen mit einem geeigneten Schmelzmittel, eingewogen und homogenisiert. Anschließend wird die Eduktmischung für mehrere Stunden unter reduzierender Atmosphare (insbesondere unter N₂ bzw. Ar oder einem Gemisch aus N₂/H₂ oder Ar/H₂) bei Temperaturen zwischen 1000°C und 1500°C geglüht. Darauf kann eine Zweitglühung, ebenfalls unter reduzierender Atmosphäre (insbesondere unter N₂ bzw. Ar oder einem Gemisch aus N₂/H₂ oder Ar/H₂) bei Temperaturen zwischen 800°C und 1400°C, erfolgen. Die Synthese wird in einem geeigneten Ofen, wie z.B. Rohr- oder Kammerofen durchgeführt.
a) Vergleichsbeispiel/Ansatzmischung 1 (Stand der Technik) :
   73,5 g SrCO₃, 98,1 g BaCO₃, 31,1 g SiO₂ und 7,2 g Eu₂O₃ ;
b) Vergleichsbeispiel/Ansatzmischung 2 (Stand der Technik):
   73,3 g SrC03, 97,9 g BaCO₃, 31,1 g SiO₂, 0,4 g LaN und 7,2 g Eu₂O₃ ;
c) Ausführungsbeispiel /Ansatzmischung 3:
   73, 4 g SrCO₃, 98,0 g BaCO₃, 30, 8 g SiO₂, 0,1 g Si₃N₄, 0,4 g La₂O₃ und 7, 2 g Eu₂O₃ ;
d) Ausführungsbeispiel/Ansatzmischung 4:
   73,3 g SrCO₃, 98,0 g BaCO₃, 30,9 g SiO₂, 0,4 g LaN und 7,2 g Es₂O₃ ;

Bereits durch den Einbau von Lanthan und Stickstoff wie in Vergleichsbeispiel 2 ist bereits bei höheren Temperaturen und in feuchter Umgebung eine deutliche Verbesserung der LED-Stabilität zu erkennen. Für viele Anwendungen, wie z. B. für LCD-Hintergrundbeleuchtung, ist diese Stabilität jedoch immer noch nicht optimal.

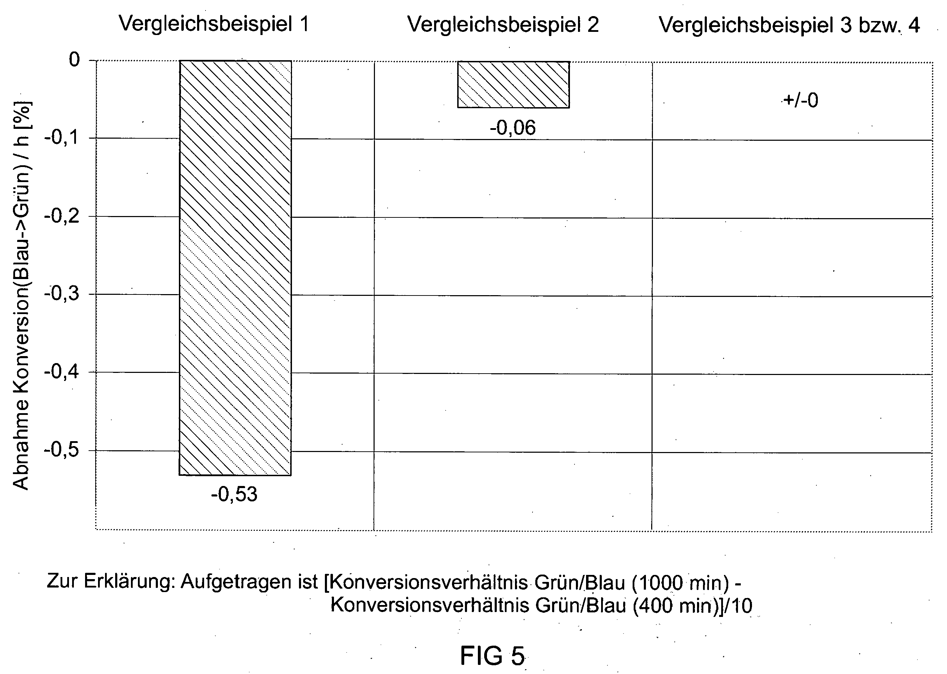

Die hier beschriebene neue Ansatzstöchiometrie gemäß Ausführungsbeispiel 3 bzw. 4 mit einem entsprechenden Unterschuss an SiO₂ führt nachweislich zu einer verbesserten LED-Stabilität, vor allem in feuchter Umgebung und bei höheren Temperaturen. In Figur 5 ist die LED-Stabilität bei einer Temperatur von 45 °C und 95% Luftfeuchtigkeit für die vier verschiedenen Ansatzmischungen dargestellt. Als Ordinate ist das relative Konversionsverhältnis aufgetragen, die Abszisse ist die Zeit in Minuten. Es zeigt sich, dass die Ausführungsbeispiele 3 und 4 etwa zueinander gleichwertig sind und beide den Vergleichsbeispielen 1 und 2 merklich überlegen sind.

Die relative Quanteneffizienzen QE₄₆₀ der neuartigen Leuchtstoffe gemäß Ausführungsbeispiel 3 und 4 bei Anregung mit 460 nm ist um 3% höher als beim Vergleichsbeispiel 2.

Die Präparation der dargestellten Nitrido-Orthosilikate der Form
EA₂₋ₓ₋ₐSEₓEuₐSi_{1-y}O_{4-x-2y}Nₓ erfolgt typischerweise aus EACO₃, SiO₂, SEN und Eu₂O₃ oder EACO₃, SiO₂, Si₃N₄, (SEN)₂O₃ und Eu₂O₃ als Ausgangssubstanzen. Im Letzteren werden die Seltenen Erden als (SEN)₂O₃ eingesetzt, wenn bevorzugt dreiwertige Oxide gebildet werden. Bei Selten-Erd-Oxiden die bevorzugt als Mischoxide vorliegen wie beispielsweise Tb gewöhnlich als III/IV Mischoxid Tb₄O₇ vorliegt, werden die Mischoxide bevorzugt eingesetzt. Weiterhin können anstelle von SEN oder SE-Oxid in Verbindung mit Si₃N4, auch In, Y oder Sc als Nitrid bzw. als eine Kombination aus Oxid und Si₃N₄ eingesetzt werden.

Weiterhin können insbesondere Fluoride und Chloride, wie EACl₂ oder SECl₂, EAF₂ oder SECl₂, aber auch NH₄Cl/NH₄F, H₃BO₃, LiF und Kryolithe, sowie Kombinationen davon, als Schmelzmittel eingesetzt werden.

Die Edukte analog der Ansatzmischungen 1 bis werden zusammen mit einem geeigneten Schmelzmittel eingewogen und homogenisiert. Anschließend wird die Eduktmischung für mehrere Stunden unter reduzierender Atmosphäre (z. B. unter N₂ bzw. Ar oder einem Gemisch aus N₂/H₂ oder Ar/H₂) bei Temperaturen zwischen 1000°C und 1500°C geglüht. Darauf kann eine Zweitglühung, ebenfalls unter reduzierender Atmosphäre (z. B. unter N₂ bzw. Ar oder einem Gemisch aus N₂/H₂ oder Ar/H₂) bei Temperaturen zwischen 800°C und 1400°C, erfolgen. Die Synthese wird in einem geeigneten Ofen, wie z.B. Rohr- oder Kammerofen durchgeführt.

### Ansatzmischung 1:

69,9 g SrCO₃, 93,3 g BaCO₃, 29,3 g SiO₂, 0,1 g Si₃N₄, 0,5 g La₂O₃ und 7,0 g Eu₂O₃

### Ansatzmischung 2:

69,9 g SrCO₃, 93,3 g BaCO₃, 29,3 g SiO₂, 0,1 g Si₃N₄, 0,4 g Per₆O₁₁ und 7,0 g Eu₂O₃

### Ansatzmischung 3:

69,9 g SrCO₃, 93,3 g BaCO₃, 29,3 g SiO₂, 0,1 g Si₃N₄, 0,4 g Nd₂O₃ und 7,0 g Eu₂O₃

### Ansatzmischung 4:

69,9 g SrCO₃, 93,3 g BaCO₃, 29,3 g SiO₂, 0,1 g Si₃N₄, 0,4 g Sm₂O₃ und 7,0 g Eu₂O₃

### Ansatzmischung 5:

69,9 g SrCO₃, 93,3 g BaCO₃, 29,3 g SiO₂, 0,1 g Si₃N₄, 0,4 g Gd₂O₃ und 7,0 g Eu₂O₃

### Ansatzmischung 6:

69,9 g SrCO₃, 93,3 g BaCO₃, 29,3 g SiO₂, 0,1 g Si₃N₄, 0,5 g Tb₄O₇ und 7,0 g Eu₂O₃

### Ansatzmischung 7:

69,9 g SrCO₃, 93,3 g BaCO₃, 29,3 g SiO₂, 0,1 g Si₃N₄, 0,5 g DY₂O₃ und 7,0 g Eu₂O₃

### Ansatzmischung 8:

69,9 g SrCO₃, 93,3 g BaCO₃, 29,3 g SiO₂, 0,1 g Si₃N₄, 0,5 g Ho₂O₃ und 7,0 g Eu₂O₃

### Ansatzmischung 9:

69,9 g SrCO₃, 93,3 g BaCO₃, 29,3 g SiO₂, 0,2 g Si₃N₄, 0,5 g Er₂O₃ und 7,0 g Eu₂O₃

### Ansatzmischung 10:

69,9 g SrCO₃, 93,3 g BaCO₃, 29,3 g SiO₂, 0,1 g Si₃N₄, 0,5 g Tm₂O₃ und 7,0 g Eu₂O₃

### Ansatzmischung 11 :

69,9 g SrCO₃, 93,3 g BaCO₃, 29,3 g SiO₂, 0,1 g Si₃N₄, 0,5 g Yb₂O₃ und 7,0 g Eu₂O₃

### Ansatzmischung 12:

69,9 g SrCO₃, 93,3 g BaCO₃, 29,3 g SiO₂, 0,1 g Si₃N₄, 0,5 g Lu₂O₃ und 7,0 g Eu₂O₃

### Ansatzmischung 13:

69,9 g SrCO₃, 93,3 g BaCO₃, 29,3 g SiO₂, 0,1 g Si₃N₄, 0,4 g Y₂O₃ und 7,0 g Eu₂O₃

### Ansatzmischung 14:

69,9 g SrCO₃, 93,3 g BaCPO₃, 29,3 g SiO₂, 0,1 g Si₃N₄, 0,2 g Sc₂O₃ und 7,0 g Eu₂O₃

### Ansatzmischung 15:

69, 9 g SrCO₃, 93,3 g BaCO₃, 29, 3 g SiO₂, 0,1 g Si₃N₄, 0,4 g In₂O₃ und 7,0 g Eu₂O₃

In der nachfolgenden Tabelle 1 ist ein Vergleich der spektralen Eigenschaften am Beispiel einer La/N-Dotierung mit und ohne SiO₂-Unterschuss wiedergegeben.

**Tab. 1**

| Zusammensetzung | λ_{exc.} [nm] | x | y | λ_{dom} [nm] | FWHM [nm] | QE[%] |
|---|---|---|---|---|---|---|
| (Ba_{0.9575}Sr_{0.9575}La_{0.005}Eu_{0.08})Si_{3.995}N_{0.005} | 460 | 0.285 | 0.638 | 545.9 | 64.2 | 87 |
| (Ba_{0.9575}Sr_{0.9575}La_{0.0005}Eu_{0.08})v | 460 | 0.285 | 0.639 | 545.9 | 64.1 | 100 |

Die spektralen Daten weiterer Ausführungsbeispiele sind in der nachfolgenden Tabelle 2 aufgeführt.

**Tab. 2**

| Zusammensetzung | λ_{exc}. [nm] | x | y | λ_{dom} [nm] | FWHM [nm] | QE%] |
|---|---|---|---|---|---|---|
| (Ba_{0.9575}Sr_{0.9575}La_{0.005}Eu_{0.08})Si_{0.9925}O_{3,9875}N_{0,005} | 460 | 0.285 | 0.639 | 545.9 | 64.1 | 1.00 |
| (Ba_{0.9575}Sr_{0.9575}Pr_{0.005}Eu_{0.08})Si_{0.9925}O_{3.9875}N_{0.005} | 460 | 0.288 | 0.636 | 546.4 | 64.4 | 0.95 |
| (Ba_{0.9575}Sr_{0.9575}Sm_{0.005}Eu_{0.08})Si_{0.9925}O_{3.9875}N_{0.005} | 460 | 0.285 | 0.638 | 545.9 | 65.0 | 0.89 |
| (Ba_{0.9575}Sr_{0.9575}Gd_{0.005}Eu_{0.08})Si_{0.9925}O_{3.9875}N_{0.005} | 460 | 0.286 | 0.637 | 546.1 | 65.4 | 0.97 |
| (Ba_{0.9575}Sr_{0.9575}Tb_{0.005}Eu_{0.08})Si_{0.9925}O_{3.9875}N_{0.005} | 460 | 0.290 | 0.637 | 546.9 | 65.2 | 1.02 |
| (Ba_{0.9575}Sr_{0.9575}Dy_{0.005}Eu_{0.08})Si_{0.9925}O_{3.9875}N_{0.005} | 460 | 0.289 | 0.637 | 546.7 | 65.1 | 1.00 |
| (Ba_{0.9575}Sr_{0.9575}Ho_{0.005}Eu_{0.08})Si_{0.9925}O_{3.9875}N_{0.005} | 460 | 0.292 | 0.635 | 547.2 | 65.7 | 0.98 |
| (Ba_{0.9575}Sr_{0.9575}Er_{0.005}Eu_{0.08})Si_{0.9925}O_{3.9875}N_{0.005} | 460 | 0.297 | 0.632 | 548.1 | 66.5 | 0.97 |
| (Ba_{0.9575}Sr_{0.9575}Tm_{0.005}Eu_{0.08})Si_{0.9925}O_{3.9875}N_{0.005} | 460 | 0.297 | 0.634 | 548.2 | 66.4 | 1.00 |
| (Ba_{0.9575}Sr_{0.9575}Yb_{0.005}Eu_{0.08})Si_{0.9925}O_{3.9875}N_{0.005} | 460 | 0.298 | 0.633 | 548.3 | 67.1 | 0.98 |
| (Ba_{0.9575}Sr_{0.9575}Lu_{0.005}Eu_{0.08})Si_{0.9925}O_{3.9875}N_{0.005} | 460 | 0.298 | 0.632 | 548.3 | 67.2 | 1.01 |
| (Ba_{0.9575}Sr_{0.9575}Y_{0.005}Eu_{0.08})Si_{0.9925}O_{3.9875}N_{0.005} | 460 | 0.294 | 0.635 | 547.6 | 65.5 | 1.02 |
| (Ba_{0.9575}Sr_{0.9575}In_{0.005}Eu_{0.08})Si_{0.9925}O_{3.9875}N_{0.005} | 460 | 0.301 | 0.630 | 548.8 | 68.0 | 0.99 |
| (B_{0.9575}Sr_{0.9575}Sc_{0.005}Eu_{0.08})Si_{0.9925}O_{3.9875}N_{0.005} | 460 | 0.296 | 0.633 | 548.0 | 66.9 | 1.00 |

## Patentansprüche

1. Blau bis Gelb emittierender Leuchtstoff aus der Klasse der Orthosilikate, der im wesentlichen die Struktur EA2SiO4:D besitzt, **dadurch gekennzeichnet, dass** der Leuchtstoff als Komponente EA mindestens eines der Elemente EA = Sr, Ba, Ca oder Mg allein oder in Kombination aufweist, wobei die aktivierende Dotierung D aus Eu besteht und wobei SiO2 im Unterschuss eingebracht ist, so dass ein modifiziertes unterstöchiometrisches Orthosilikat vorliegt, wobei das Orthosilikat mit SE und N stabilisiert ist, mit SE = Seltenerdmetall, wobei die Stöchiometrie des modifizierten Orthosilikats der Formel EA₂₋ₓ₋ₐSEₓEuₐSi_{1-y}O_{4-x-2y}Nₓ entspricht, wobei der Anteil a des Eu zwischen a = 0,01 und 0,20 beträgt, wobei der Anteil x zwischen 0,003 und 0,02 beträgt und wobei der für den Unterschuss maßgebende Faktor y im Bereich von 0,002 ≤ y ≤ 0,02 liegt.

2. Leuchtstoff nach Anspruch 1, **dadurch gekennzeichnet, dass** SE = La oder Y allein oder in Kombination ist.

3. Leuchtstoff nach Anspruch 1, **dadurch gekennzeichnet, dass** EA Sr und/oder Ba mit mindestens 66 mol-% enthält, insbesondere mit einem Anteil des Ca von maximal 5 mol-% und insbesondere mit einem Anteil des Mg von maximal 30 mol-%.

4. Lichtquelle mit einer primären Strahlungsquelle, die Strahlung im kurzwelligen Bereich des optischen Spektralbereichs im Wellenlängenbereich 140 bis 480 nm emittiert, wobei diese Strahlung mittels eines ersten Leuchtstoffs nach einem der vorhergehenden Ansprüche ganz oder teilweise in sekundäre längerwellige Strahlung im sichtbaren Spektralbereich konvertiert wird.

5. Lichtquelle nach Anspruch 4, **dadurch gekennzeichnet, dass** als primäre Strahlungsquelle eine Leuchtdiode auf Basis von InGaN oder InGaAlP oder eine Entladungslampe auf Niederdruck-oder Hochdruckbasis, insbesondere mit einer Indiumhaltigen Füllung, oder eine elektrolumineszente Lampe verwendet wird.

6. Lichtquelle nach Anspruch 4, **dadurch gekennzeichnet, dass** ein Teil der primären Strahlung weiterhin mittels weiterer Leuchtstoffe in längerwellige Strahlung konvertiert wird, wobei die Leuchtstoffe insbesondere geeignet gewählt und gemischt sind um weißes Licht zu erzeugen.

7. Verfahren zur Herstellung eines hocheffizienten Leuchtstoffs nach einem der Ansprüche 1 bis 3, **gekennzeichnet durch** folgende Verfahrensschritte:
a) Bereitstellen der Ausgangsstoffe SiO2 allein oder in Kombination mit Si₃N₄ als Si-Komponente, sowie mindestens eines SE-Vorläufers ausgewählt aus der Gruppe SEN oder SE203, sowie mindestens eines EA-Vorläufers, bevorzugt EAC03, insbesondere mindestens ein Vorläufer aus der Gruppe SrCO₃, BaCO₃, CaCO₃ und MgO, sowie eines Eu-Vorläufers, insbesondere Eu203, wobei die Si-Komponente in unterstöchiometrischem Anteil bereitgestellt wird;
b) Mischen der Ausgangsstoffe und Glühung für mindestens 1 Std. unter reduzierender Atmosphäre bei Temperaturen von 1000 bis 1500 °C;
c) ggf. anschließendes zweites Glühen des in Schritt b) hergestellten Leuchtstoffs bei 800 bis 1400 °C.

8. Verfahren nach Anspruch 7, **dadurch gekennzeichnet, dass** Fluoride oder Chloride, insbesondere mindestens eines aus der Gruppe EAF2, EAC12, REC12 oder REF2, oder von Ammonium, oder von H3B03, oder LiF oder Kryolithe allein oder in Kombination als Schmelzmittel beim Schritt a) und/oder beim Schritt c) eingesetzt werden.

9. Konversions-LED mit einem Chip, der primäre Strahlung emittiert, sowie einer dem Chip vorgelagerten Leuchtstoff enthaltenden Schicht, die mindestens einen Teil, der primären Strahlung des Chips in sekundäre Strahlung konvertiert, wobei ein Leuchtstoff gemäß einem der Ansprüche 1 bis 3 verwendet wird.

10. Konversions-LED nach Anspruch 9, **dadurch gekennzeichnet, dass** als weiterer Leuchtstoff (Lu,Y,Gd)₃(Al,Ga)₅O₁₂:Ce verwendet wird.

11. Konversions-LED nach Anspruch 9, **dadurch gekennzeichnet, dass** als weiterer Leuchtstoff ein durch Cu modifiziertes CaAlSiN3:Eu verwendet wird.

## Claims

1. Blue- to yellow-emitting luminophore from the class of the orthosilicates having essentially the EA₂SiO₄:D structure, **characterized in that** the luminophore includes, as component EA, at least one of the elements EA = Sr, Ba, Ca or Mg, alone or in combination, where the activating doping D consists of Eu and where SiO₂ has been introduced in deficiency, such that a modified substoichiometric orthosilicate is present, where the orthosilicate has been stabilized with SE and N with SE = rare earth metal, where the stoichiometry of the modified orthosilicate corresponds to the formula EA₂₋ₓ₋ₐSEₓEuₐSi_{1-y}O_{4-x-2y}Nₓ where the proportion a of Eu is between a = 0.01 and 0.20, where the proportion x is between 0.003 and 0.02 and where the factor y, which is the crucial factor for the deficiency, is in the range of 0.002 ≤ y ≤ 0.02.

2. Luminophore according to Claim 1, **characterized in that** SE = La or Y, alone or in combination.

3. Luminophore according to Claim 1, **characterized in that** EA contains Sr and/or Ba with at least 66 mol%, especially with a proportion of Ca of not more than 5 mol% and especially with a proportion of Mg of not more than 30 mol%.

4. Light source having a primary radiation source that emits radiation in the short-wave range of the optical spectral region in the wavelength range of 140 to 480 nm, wherein this radiation is converted wholly or partly by means of a first luminophore according to any of the preceding claims to secondary longer-wave radiation in the visible spectral region.

5. Light source according to Claim 4, **characterized in that** the primary radiation source used is a light-emitting diode based on InGaN or InGaAlP or a discharge lamp based on low pressure or high pressure, especially having an indium-containing filling, or an electroluminescent lamp.

6. Light source according to Claim 4, **characterized in that** some of the primary radiation is also converted by means of further luminophores to longer-wave radiation, the luminophores being chosen and mixed in an especially suitable manner to produce white light.

7. Process for producing a highly efficient luminophore according to any of Claims 1 to 3, **characterized by** the following process steps:
a) providing the starting materials SiO₂ alone or in combination with Si₃N₄ as the Si component, and at least one SE precursor selected from the group of SEN and SE₂O₃, and at least one EA precursor, preferably EACO₃, especially at least one precursor from the group of SrCO₃, BaCO₃, CaCO₃ and MgO, and an Eu precursor, especially Eu₂O₃, where the Si component is provided in a substoichiometric proportion;
b) mixing the starting materials and calcining under a reducing atmosphere at temperatures of 1000 to 1500°C for at least 1 h;
c) optionally subjecting the luminophore produced in step b) to a subsequent second calcination at 800 to 1400°C.

8. Process according to Claim 7, **characterized in that** fluorides or chlorides, especially at least one from the group of EAF₂, EACl₂, RECl₂ and REF₂, or of ammonium, or of H₃BO₃, or LiF or cryolite, alone or in combination, are used as fluxes in step a) and/or in step c).

9. Conversion LED having a chip that emits primary radiation, and a luminophore-containing layer upstream of the chip that converts at least a portion of the primary radiation from the chip to secondary radiation, wherein a luminophore according to any of Claims 1 to 3 is used.

10. Conversion LED according to Claim 9, **characterized in that** a further luminophore used is (Lu,Y,Gd)₃(Al,Ga)₅O₁₂:Ce.

11. Conversion LED according to Claim 9, **characterized in that** a further luminophore used is a Cu-modified CaAlSiN₃:Eu.

## Revendications

1. Substance luminescente émettant dans le bleu au jaune de la classe des orthosilicates, qui présente essentiellement la structure EA2SiO4:D, **caractérisée en ce que** la substance luminescente présente, comme composant EA, au moins un des éléments EA = Sr, Ba, Ca ou Mg, seuls ou en combinaison, le dopage activant D étant constitué d'Eu et Si02 étant incorporé en une quantité inférieure à la quantité stoechiométrique de manière telle qu'on est en présence d'un orthosilicate modifié de manière sous-stoechiométrique, l'orthosilicate étant stabilisé par SE et N, SE = un métal de terres rares, la stoechiométrie de l'orthosilicate modifié correspondant à la formule EA₂₋ₓ₋ₐSEₓEuₐSi_{1-y}O_{4-x-2y}Nₓ, la proportion a de l'Eu étant située entre a = 0,01 et 0,20, la proportion x étant située entre 0,003 et 0,02 et le facteur y déterminant pour la quantité inférieure à la quantité stoechiométrique étant situé dans la plage de 0,002 ≤ Y ≤ 0,02.

2. Substance luminescente selon la revendication 1, **caractérisée en ce que** SE = La ou Y, seuls ou en combinaison.

3. Substance luminescente selon la revendication 1, **caractérisée en ce que** EA contient du Sr et/ou du Ba à raison d'au moins 66% en mole, en particulier avec une proportion de Ca d'au maximum 5% en mole et en particulier avec une proportion de Mg d'au maximum 30% en mole.

4. Source de lumière présentant une source de rayonnement primaire, qui émet un rayonnement dans la plage des courtes longueurs d'onde du domaine spectral optique, dans la plage de longueurs d'onde de 140 à 480 nm, ce rayonnement étant converti, totalement ou partiellement, au moyen d'une première substance luminescente selon l'une quelconque des revendications précédentes en rayonnement secondaire de longueur d'onde plus longue dans la plage spectrale visible.

5. Source de lumière selon la revendication 4, **caractérisée en ce qu'**on utilise, comme source de rayonnement primaire, une diode électroluminescente à base d'InGaN ou d'InGaAlP ou une lampe à décharge basse ou haute pression, présentant en particulier un remplissage contenant de l'indium, ou une lampe électroluminescente.

6. Source de lumière selon la revendication 4, **caractérisée en ce qu'**une partie du rayonnement primaire est en outre convertie au moyen d'autres substances luminescentes en un rayonnement de longueur d'onde plus longue, les substances luminescentes étant en particulier choisies et mélangées de manière appropriée pour générer de la lumière blanche.

7. Procédé pour la préparation d'une substance luminescente hautement efficace selon l'une quelconque des revendications 1 à 3, **caractérisé par** les étapes suivantes consistant à:
a) préparer les substances de départ SiO2, seul ou en combinaison avec du Si₃N₄ comme composant de Si, ainsi qu'au moins un précurseur de SE choisi dans le groupe formé par SEN ou SE203, ainsi qu'au moins un précurseur d'EA, de préférence EAC03, en particulier au moins un précurseur du groupe SrCO₃, BaCO₃, CaCO₃ et MgO, ainsi qu'un précurseur d'Eu, en particulier Eu₂O₃, le composant de Si étant préparé en une proportion inférieure à la quantité stoechiométrique;
b) mélanger les substances de départ et calciner pendant au moins 1 heure sous atmosphère réductrice à des températures de 1000 à 1500°C;
c) le cas échéant réaliser une deuxième calcination consécutive de la substance luminescente préparée dans l'étape b) à 800 jusqu'à 1400°C.

8. Procédé selon la revendication 7, **caractérisé en ce qu'**on utilise des fluorures ou des chlorures, en particulier au moins l'un du groupe formé par EAF2, EAC12, REC12 ou REF2 ou de l'ammonium ou du H3BO3, du LiF ou du cryolithe, seuls ou en combinaison, comme fondant lors de l'étape a) et/ou lors de l'étape c).

9. LED de conversion présentant une puce qui émet un rayonnement primaire ainsi qu'une couche contenant une substance luminescente disposée en amont de la puce, qui convertit au moins une partie du rayonnement primaire de la puce en rayonnement secondaire, une substance luminescente selon l'une quelconque des revendications 1 à 3 étant utilisée.

10. LED de conversion selon la revendication 9, **caractérisé en ce qu'**on utilise, comme autre substance luminescente, (Lu,Y,Gd)₃(Al,Ga)₅O₁₂:Ce.

11. LED de conversion selon la revendication 9, **caractérisé en ce qu'**on utilise, comme autre substance luminescente, un CaAlSiN3:Eu modifié par Cu.
